# EUROPEAN PATENT APPLICATION

(11) **EP 3 188 215 A2**
(43) Date of publication of application: **05.07.2017**
(21) Application number: 16163887.9
(22) Date of filing: 09.02.2011
(51) Int. Cl.: H01J 37/317, H01L 21/266

(54) **AN ADJUSTABLE SHADOW MASK ASSEMBLY FOR USE IN SOLAR CELL FABRICATIONS**

(30) Priority: 09.02.2010 US 302861 P
(62) Divisional of application: 11742754.2
(71) Applicant: Intevac, Inc., Santa Clara, CA 95054 (US)
(72) Inventor: CHUN, Moon, San Jose, CA 95120 (US); ADIBI, Babak, Los Altos, CA (US)
(74) Representative: Puschmann Borchert Bardehle Patentanwälte Partnerschaft mbB

(57) **Abstract**

An adjustable shadow mask implantation system comprising:
an ion source configured to provides ions; and an shadow mask assembly configured to selectively allow ions from the ion source to pass there through to a substrate where they are implanted, wherein the shadow mask assembly is configured to adjust between a first position and a second position,
wherein the shadow mask assembly enables ion implantation of multiple substantially parallel lines absent any lines with an intersecting orientation with respect to the multiple substantially parallel lines when set in the first position, and wherein the shadow mask assembly enables ion implantation of multiple substantially parallel lines and a line with an intersecting orientation with respect to the multiple substantially parallel lines when set in the second position.

## Description

This application claims priority to co-pending U.S. Provisional Application Serial Number 61/302,861, filed February 9, 2010, entitled "AN ADJUSTABLE SHADOW MASK ASSEMBLY FOR USE IN SOLAR CELL FABRICATIONS," which is hereby incorporated by reference in its entirety as if set forth herein.

The present invention relates generally to the field of solar cells and other large substrate implant applications. More particularly, the present invention relates to solar cell devices and methods of their formation, including the issue of selective implantation.

In one aspect of the present invention, an adjustable shadow mask implantation system comprises: an ion source configured to provide ions; and an shadow mask assembly configured to selectively allow ions from the ion source to pass there through to a substrate where they are implanted, wherein the shadow mask assembly is configured to adjust between a first position and a second position, wherein the shadow mask assembly enables ion implantation of multiple substantially parallel lines absent any lines with an intersecting orientation with respect to the multiple substantially parallel lines when set in the first position, and wherein the shadow mask assembly enables ion implantation of multiple substantially parallel lines and a line with an intersecting orientation with respect to the multiple substantially parallel lines when set in the second position. In some embodiments, the multiple parallel lines are substantially perpendicular to the line with the intersecting orientation.

In some embodiments, the shadow mask assembly comprises: a first exposure region having multiple elongated openings substantially parallel to a first axis; and a second exposure region having an elongated opening substantially parallel to a second axis, wherein the second axis is substantially perpendicular to the first axis, wherein the shadow mask assembly is configured to adjust between the first position and the second position by adjusting the distance between the first exposure region and the second exposure region. In some embodiments, the first exposure region comprises: a first occlusion mask having a first set of elongated openings substantially parallel to a first axis; and a second occlusion mask having a second set of elongated openings substantially parallel to the first axis, wherein the first occlusion mask and the second occlusion mask are configured such that the first set of elongated openings overlap with, but are offset from, the second set of elongated openings to form the multiple elongated openings of the first exposure region, the multiple elongated openings of the first exposure region being smaller than each one of the elongated openings in the first set of the first occlusion mask and the second set of the second occlusion mask. In some embodiments, the shadow mask assembly further comprises a homogeneous exposure region configured to enable a blanket homogeneous implantation of the substrate from the ions.

In some embodiments, the system further comprises: a moveable substrate holder configured to move the substrate at a velocity through the path of the ions passing through the shadow mask assembly; and a controller operationally coupled to the moveable substrate holder, wherein the controller is configured to adjust the velocity to a first level for the first position and to a second level for the second position. In some embodiments, the second level is a lower velocity than the first level. In some embodiments, the moveable substrate holder is configured to rotate the substrate through the path of the ions passing through the shadow mask assembly. In some embodiments, the shadow mask assembly comprises: a first exposure member having multiple elongated openings substantially parallel to a first axis, wherein the length of the multiple elongated openings is greater the farther away they are from the point of rotation about which the substrate is rotated; and a second exposure member having an elongated opening configured in an intersecting orientation relative to the first axis, wherein the elongated opening gets wider as it extends away from the point of rotation about which the substrate is rotated, wherein the shadow mask assembly is configured to adjust between the first position and the second position by adjusting the distance between the first exposure member and the second exposure member. In some embodiments, the multiple elongated openings are curved.

In another aspect of the present invention, a method of ion implantation comprises: flowing ions through a shadow mask assembly to a substrate; adjusting the shadow mask assembly to a first position, wherein the substrate is selectively implanted with multiple substantially parallel lines of ions absent any lines of ions with an intersecting orientation with respect to the multiple substantially parallel lines; and adjusting the shadow mask assembly to a second position, wherein the substrate is selectively implanted with multiple substantially parallel lines of ions and a line of ions with an intersecting orientation with respect to the multiple substantially parallel lines. In some embodiments, the multiple parallel lines are substantially perpendicular to the line with the intersecting orientation.

In some embodiments, the shadow mask assembly comprises: a first exposure region having multiple elongated openings substantially parallel to a first axis; and a second exposure region having an elongated opening substantially parallel to a second axis, wherein the second axis is substantially perpendicular to the first axis, wherein the shadow mask assembly is configured to adjust between the first position and the second position by adjusting the distance between the first exposure region and the second exposure region. In some embodiments, the first exposure region comprises: a first occlusion mask having a first set of elongated openings substantially parallel to a first axis; and a second occlusion mask having a second set of elongated openings substantially parallel to the first axis, wherein the first occlusion mask and the second occlusion mask are configured such that the first set of elongated openings overlap with, but are offset from, the second set of elongated openings to form the multiple elongated openings of the first exposure region, the multiple elongated openings of the first exposure region being smaller than each one of the elongated openings in the first set of the first occlusion mask and the second set of the second occlusion mask. In some embodiments, the method further comprises flowing ions through a homogeneous exposure region of the shadow mask assembly, thereby providing a blanket homogeneous implantation of the substrate from the ions.

In some embodiments, the method further comprises: a substrate holder moving the substrate at a velocity through the path of the ions passing through the shadow mask assembly; and a controller adjusting the velocity to a first level for the first position and to a second level for the second position. In some embodiments, the second level is a lower velocity than the first level. In some embodiments, the moveable substrate holder rotates the substrate through the path of the ions passing through the shadow mask assembly. In some embodiments, the shadow mask assembly comprises: a first exposure member having multiple elongated openings substantially parallel to a first axis, wherein the length of the multiple elongated openings is greater the farther away they are from the point of rotation about which the substrate is rotated; and a second exposure member having an elongated opening configured in an intersecting orientation relative to the first axis, wherein the elongated opening gets wider as it extends away from the point of rotation about which the substrate is rotated, wherein the shadow mask assembly is configured to adjust between the first position and the second position by adjusting the distance between the first exposure member and the second exposure member. In some embodiments, the multiple elongated openings are curved.

In some embodiments, the ions are flown or accelerated through the shadow mask assembly to the substrate from an ion source, the ion source comprising at least two different ion species having different masses.

In some embodiments, the method further comprises applying a voltage selectively to spaced apart regions on a side of the substrate opposite the shadow mask assembly, wherein the selective application of voltage promotes the selective implantation of ions.

In some embodiments, the shadow mask assembly is part of a first grid assembly, the first grid assembly comprising a first grid plate and a second grid plate, each grid plate of the first grid assembly having a plurality of apertures configured to allow ions to pass there through, the first grid plate of the first grid assembly being positively biased by a power supply, the second grid plate of the first grid assembly being negatively biased by the power supply, the method comprising the ions flowing through the first grid assembly for selective implantation of the substrate. In some embodiments, a second grid plate is coupled to the first grid assembly via a voltage divider, the second grid assembly comprising a first grid plate and a second grid plate, each grid plate of the second grid assembly having a plurality of apertures configured to allow ions to pass there through, the first grid plate of the second grid assembly being positively biased by the power supply, the second grid plate of the second grid assembly being negatively biased by the power supply, the method comprising the ions flowing through the second grid assembly for implantation of the substrate.

In yet another aspect of the present invention, a shadow mask implantation system comprises: an ion source configured to provide ions; a first occlusion mask having a first set of elongated openings substantially parallel to a first axis; and a second occlusion mask having a second set of elongated openings substantially parallel to the first axis, wherein the first occlusion mask and the second occlusion mask are configured such that the first set of elongated openings overlap with, but are offset from, the second set of elongated openings to form a resulting set of elongated openings through which ions from the ion source are selectively allowed to pass there through to a substrate where they are implanted, each elongated opening of the resulting set being smaller than each elongated opening of the first and second sets.

In some embodiments, the thickness of each elongated opening of the resulting set is equal to or less than half the thickness of each elongated opening of the first and second sets. In some embodiments, the thickness of each elongated opening of the resulting set is equal to or less than 50 microns.

In some embodiments, the system further comprises a shadow mask assembly having a first exposure region and a second exposure region, wherein: the first occlusion mask and the second occlusion mask form the first exposure region comprising the resulting set of elongated openings substantially parallel to the first axis; the second exposure region has an elongated opening substantially parallel to a second axis, wherein the second axis is substantially perpendicular to the first axis; the shadow mask assembly is configured to adjust between a first position and a second position by adjusting the distance between the first exposure region and the second exposure region; the shadow mask assembly enables ion implantation of multiple substantially parallel lines absent any lines with an intersecting orientation with respect to the multiple substantially parallel lines when set in the first position, the multiple substantially parallel lines corresponding to the resulting set of elongated openings; and the shadow mask assembly enables ion implantation of multiple substantially parallel lines and a line with an intersecting orientation with respect to the multiple substantially parallel lines when set in the second position, the multiple substantially parallel lines corresponding to the resulting set of elongated openings. In some embodiments, the multiple parallel lines are substantially perpendicular to the line with the intersecting orientation. In some embodiments, the system further comprises: a moveable substrate holder configured to move the substrate at a velocity through the path of the ions passing through the shadow mask assembly; and a controller operationally coupled to the moveable substrate holder, wherein the controller is configured to adjust the velocity to a first level for the first position and to a second level for the second position, the second level being a lower velocity than the first level.

In yet another aspect of the present invention, a method of ion implantation comprises: flowing or accelerating ions through a shadow mask assembly to a substrate, wherein the shadow mask assembly comprises a first occlusion mask having a first set of elongated openings substantially parallel to a first axis and a second occlusion mask having a second set of elongated openings substantially parallel to the first axis, wherein the first occlusion mask and the second occlusion mask are configured such that the first set of elongated openings overlap with, but are offset from, the second set of elongated openings to form a resulting set of elongated openings through which ions from the ion source are selectively allowed to pass there through to the substrate, each elongated opening of the resulting set being smaller than each elongated opening of the first and second sets; and implanting the ions into the substrate, thereby forming multiple substantially parallel lines of ion implantations corresponding to the resulting set of elongated openings.

In some embodiments, the thickness of each elongated opening of the resulting set is equal to or less than half the thickness of each elongated opening of the first and second sets. In some embodiments, wherein the thickness of each elongated opening of the resulting set is equal to or less than 50 microns. In some embodiments, a shadow mask assembly has a first exposure region and a second exposure region, the first occlusion mask and the second occlusion mask form the first exposure region comprising the resulting set of elongated openings substantially parallel to the first axis, the second exposure region has an elongated opening substantially parallel to a second axis, wherein the second axis is substantially perpendicular to the first axis, the shadow mask assembly is configured to adjust between a first position and a second position by adjusting the distance between the first exposure region and the second exposure region, the shadow mask assembly enables ion implantation of multiple substantially parallel lines absent any lines with an intersecting orientation with respect to the multiple substantially parallel lines when set in the first position, the multiple substantially parallel lines corresponding to the resulting set of elongated openings, and the shadow mask assembly enables ion implantation of multiple substantially parallel lines and a line with an intersecting orientation with respect to the multiple substantially parallel lines when set in the second position, the multiple substantially parallel lines corresponding to the resulting set of elongated openings. In some embodiments, the multiple parallel lines are substantially perpendicular to the line with the intersecting orientation. In some embodiments, the method further comprises: a moveable substrate holder moving the substrate at a velocity through the path of the ions passing through the shadow mask assembly; and a controller adjusting the velocity to a first level for the first position and to a second level for the second position, the second level being a lower velocity than the first level.

Further advantages, features and potential applications of the present invention may be gathered from the description which follows, in conjunction with the embodiments illustrated in the drawings.

Throughout the description, the claims and the drawings, those terms and associated reference signs will be used as are notable from the enclosed list of reference signs. In the drawings is shown
Fig. 1 illustrates a plan view of one embodiment of an adjustable shadow mask implantation system in accordance with the principles of the present invention.
Fig. 2 illustrates a perspective view of one embodiment of an adjustable shadow mask assembly in accordance with the principles of the present invention.
Figs. 3A-B illustrate a plan view of one embodiment of an adjustable shadow mask assembly in closed and open positions in accordance with the principles of the present invention.
Figs. 4A-B illustrate a plan view of another embodiment of an adjustable shadow mask assembly in closed and open positions in accordance with the principles of the present invention.
Fig. 5 is a graph illustrating one embodiment of a stage speed control scheme in accordance with the principles of the present invention.
Figs. 6A-B illustrate apian exploded and assembled view of one embodiment of an occlusion mask assembly in accordance with the principles of the present invention.
Fig. 7 illustrates a plan view of one embodiment of a rotating wafer processing scheme in accordance with the principles of the present invention.
Fig. 8 illustrates a plan view of another embodiment of a rotating wafer processing scheme in accordance with the principles of the present invention.
Figs. 9A-9B illustrate a plan view of one embodiment of an adjustable shadow mask assembly for the rotating wafer processing scheme in accordance with the principles of the present invention.
Fig. 10 is a flow chart illustrating on embodiment of a method of ion implantation in accordance with the principles of the present invention.
Fig. 11 illustrates a cross-sectional side view of one embodiment of a plasma grid implantation system with multiple grid assemblies in accordance with the principles of the present invention.
Fig. 12 illustrates a one embodiment of a dopant junction profile in accordance with the principles of the present invention.
Fig. 13 illustrates a cross-sectional view of one embodiment of selectively implanting a solar cell by applying a voltage to the substrate in accordance with the principles of the present invention.
Fig. 14 illustrates a cross-sectional view of another embodiment of selectively implanting a solar cell by applying a voltage to the substrate in accordance with the principles of the present invention, and
Fig. 15 illustrates a cross-sectional side view of an alternative embodiment of a plasma grid implantation system with multiple grid assemblies in accordance with the principles of the present invention.

The following description is presented to enable one of ordinary skill in the art to make and use the invention and is provided in the context of a patent application and its requirements. Various modifications to the described embodiments will be readily apparent to those skilled in the art and the generic principles herein may be applied to other embodiments. Thus, the present invention is not intended to be limited to the embodiment shown but is to be accorded the widest scope consistent with the principles and features described herein.

Furthermore, it is contemplated that any features from any embodiment can be combined with any features from any other embodiment. In this fashion, hybrid configurations of the illustrated embodiments are well within the scope of the present invention.

Various aspects of the disclosure maybe described through the use of flowcharts. Often, a single instance of an aspect of the present disclosure may be shown. As is appreciated by those of ordinary skill in the art, however, the protocols, processes, and procedures described herein may be repeated continuously or as often as necessary to satisfy the needs described herein. Additionally, it is contemplated that method steps can be performed in a different order than the order illustrated in the figures, unless otherwise disclosed explicitly or implicitly.

The present invention is directed towards a series of mechanisms that enable the formation of patterned implant doping, deposition and evaporation of various elements. One benefit of the present invention is that it can achieve such implantation without the use of any additional lithographic or other external masking. The shadow-defining mask of the present invention preferably resides within, or can be translated into, a doping or deposition system. An adjustable shadow mask assembly is disclosed that is not only tailored for the manufacturing of solar cells, but that can be used for semiconductor and other surface and near-surface modification applications as well. Various embodiments of the mask can be used in an in-line system with stationary or continuously-moving wafers. It can also be used with a linear or a rotary system, thereby enabling complete scanning of the wafers with an ion beam. This mask can provide accurate and well-defined doping and deposition patterns, as well as unique atomic profile tailoring capability for solar cells, incorporating features from commonly-owned U.S. Patent Application No. 12/483,017, entitled "FORMATION OF SOLAR CELL-SELECTIVE EMITTER USING IMPLANT AND ANNEAL METHOD," filed June 11,2009, and from commonly-owned U.S. Provisional Application No. 61/131,698, entitled "FORMATION OF SOLAR CELL-SELECTIVE EMITTER USING IMPLANT AND ANNEAL METHOD," filed June 11, 2008, which are both hereby incorporated by reference as if set forth herein. These include change in doping levels, resistance of contact, bus bar, fingers, contact resistance of metal-silicon interface, resistance of backside metallization, achieving the desired resistivity under the metal grid contact (preferably 10 to 30 Ohms/Sq.) and in between the fingers (preferably 80-100 Ohms/Sq.) to meet higher efficiency solar cells. To achieve these benefits, the present invention can incorporate features from commonly-owned U.S. Patent Application No. 12/482,980, entitled "SOLAR CELL FABRICATION USING IMPLANTATION," filed June 11, 2009, commonly-owned U.S. Provisional Application No. 61/131,687, entitled "SOLAR CELL FABRICATION USING IMPLANTATION," filed June 11, 2008, commonly-owned U.S. Patent Application No. 12/482,685, entitled "SOLAR CELL FABRICTION WITH FACETING AND ION IMPLANTATION," filed June 11, 2009, and commonly-owned U.S. Provisional Application No. 61/133,028, entitled "SOLAR CELL FABRICATION WITH FACETING AND ION IMPLANTATION," filed June 24,2008, which are all hereby incorporated by reference as if set forth herein. The present invention also meets the demands of future requirements for solar cell wafer thickness, as well as contact metal width and spacing.

Moreover, the advantageous formation of simultaneous homogenous and selective patterned emitter, Back Surface Field (BSF) and metal-implanted silicide, as well as the present invention's ability to improve performance will be possible, and can incorporate features from commonly-owned U.S. Patent Application No. 12/482,947, entitled "APPLICATION SPECIFIC IMPLANT SYSTEM AND METHOD FOR USE IN SOLAR CELL FABRICATIONS," filed June 11, 2009, commonly-owned U.S. Provisional Application No. 61/131,688, entitled "APPLICATIONS SPECIFIC IMPLANT SYSTEM AND METHOD FOR USE IN SOLAR CELL FABRICATIONS," filed June 11,2008, commonly-owned U.S. Provisional Application Serial Number 61/210,545, entitled "ADVANCED HIGH EFFICIENCY CRYSTALLINE SOLAR CELL FABRICATION METHOD," filed March 20, 2009, and commonly-owned U.S. Patent Application No. 12/728,105, entitled "ADVANCED HIGH EFFICIENCY CRYSTALLINE SOLAR CELL FABRICATION METHOD," filed March 19, 2010, which are all hereby incorporated by reference as if set forth herein. The present invention can be applied to as-grown single or mono-crystalline, poly or multi-crystalline or electrical-grade or metallurgical-grade silicon, as well as very thin silicon wafers and very thin film deposited silicon, or other materials used for solar cell formation and other applications. The present invention can also be applied to multi-junction devices, and can be extended to atomic species placement for any other material used in fabrication of junctions and metal semiconductor interface enhancements.

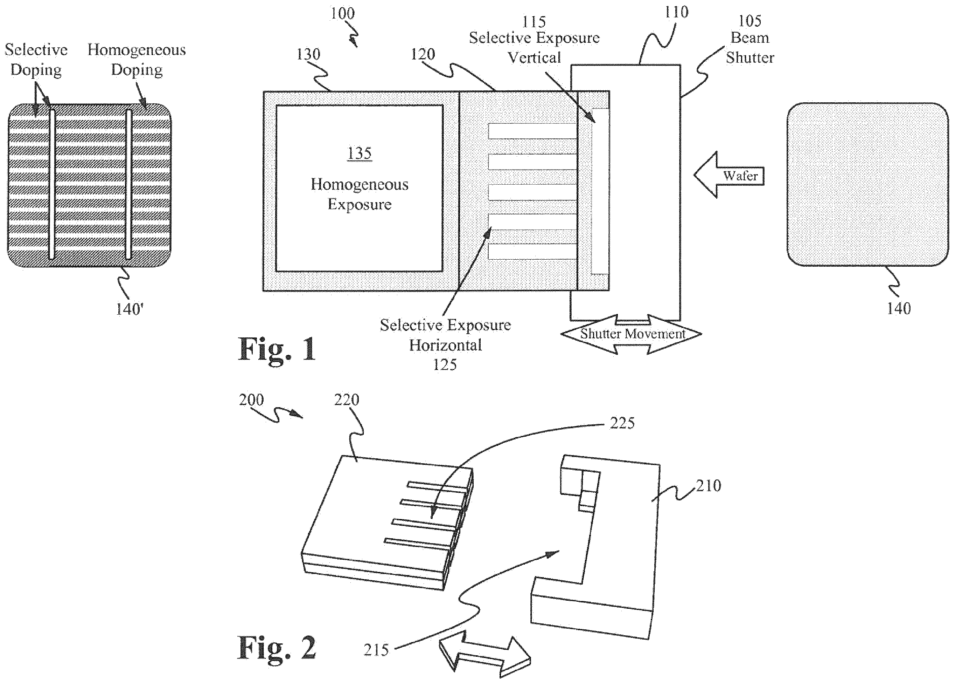

One of the main features of the present invention is a fast beam shutter mechanism used to define the typical busbar patterns. Fig. 1 illustrates one embodiment of an adjustable shadow mask implantation system 100 used to define busbar patterns with selective vertical doping and contact gridlines with selective horizontal doping in accordance with the principles of the present invention. The solar cell, semi-conducting wafer, or any substrate 140 to be modified by the ion source is introduced to the shadow mask assembly 100. The shadow mask assembly 100 comprises a vertical exposure member 110 and a horizontal exposure member 120. A predetermined mask pattern is defined by the configuration of the vertical exposure member 110 and the horizontal exposure member 120. The vertical exposure member 110 comprises an elongated vertical opening 115 for selective exposure of the substrate 140 to a vertically-elongated ion beam. The horizontal exposure member 120 comprises multiple horizontal openings 125 for selective exposure of the substrate 140 to multiple horizontally-elongated ion beams. When only horizontally-elongated ion beams are desired, the shadow mask assembly 100 is configured to make an adjustment so that the elongated vertical opening 115 is blocked, thereby preventing any ions from reaching the substrate 140 to form a vertically-elongated ion implantation. During this time, multiple horizantally-elongated ion implantations are formed in the substrate 140, as seen by the multiple white horizontal lines that have been selectively doped onto the resulting solar cell 140'. When vertically-elongated ion beams are also desired, the shadow mask assembly 100 is configured to make an adjustment so that the elongated vertical opening 115 is exposed, thereby allowing ions to reach the substrate 140 to form a vertically-elongated ion
implantation, such as the two white vertical lines that have been selectively doped onto the resulting solar cell 140'.

In some embodiments, a fast shutter mechanism is provided on the shadow mask assembly 100 and is configured to quickly block or un-block the elongated vertical opening 115, such as by adjusting the positioning of a beam shutter 105 to block the elongated vertical opening 115. The adjustment lasts for the required duration, thereby exposing the substrate 140 to the desired ion dose with the predetermined mask pattern.

In some embodiments, a homogeneous exposure member 130 is also coupled to the adjustable shadow mask assembly 100. The homogeneous exposure member 130 comprises an opening 135 configured to allow a blanket ion implantation of the substrate 140 to provide a homogeneous doping of the substrate, as seen by the dark regions on the resulting substrate 140'.

The resulting substrate 140' represents the typical crystalline solar cell metal lines. The adjustable shadow mask assembly 100 allows vertical and horizontal, as well as homogeneous, exposure of ion beams to a wafer. The wafer can be moved underneath the shadow mask assembly 100 in steady state or truncated movement, or it can be modified to cater for stop-exposure and move pattern. As described above, the beam shutter 105 is deployed when the vertical line exposure is not needed and is used only for the exposure time required. The horizontal openings 125 trace dopant lines underneath the metal gridlines on a solar cell as the wafer moves beneath them. The length and width of these lines can be either manually or automatically adjusted to provide the desired exposure and doping levels.

In some embodiment, the shadow mask assembly 100 is configured to quickly block or un-block the elongated vertical opening 115 by adjustmg the positioning of the vertical exposure member 110 or the horizontal exposure member 120 with respect to one another to block the elongated vertical opening 115.

In Fig. 2, a shadow mask assembly 200 is operated by moving the fast shutter to define the vertical busbar pattern, while exposing the horizontal finger patterns. A vertical exposure member 210 comprises an elongated vertical opening 215 for selective exposure of the substrate to a vertically-elongated ion beam. In some embodiments, the elongated vertical opening 215 is a cut-out on the side of the vertical exposure member 210. The horizontal exposure member 220 comprises multiple horizontal openings 225 for selective exposure of the substrate to multiple horizontally-elongated ion beams. In some embodiments, the horizontal openings 225 are cut-outs on the side of the horizontal exposure member 220.

In some embodiments, either the homogeneous doping or the selective patterned doping or both can be processed. In some embodiments, the timing of the wafer passage and shutter opening can be interrelated and define the necessary exposure.

In a preferred embodiment, the multiple horizontal lines are substantially parallel to one another and perpendicular to the vertical busbar lines. However, it is contemplated that other configurations are within the scope of the present invention. Furthermore, in some embodiments, instead of or in addition to elongated horizontal lines, the openings in the shadow mask can comprise other shapes as well, including, but not limited to, circular point openings or ring-shaped openings. In some embodiments where the elongated horizontal implantation lines on the substrate are replaced by rows and columns of such spaced-apart circular- or other-shaped implantations, a surface of the substrate can be blanketed with a conducting material to contact each individual contact collection region, instead of or in addition to using the busbar collection lines.

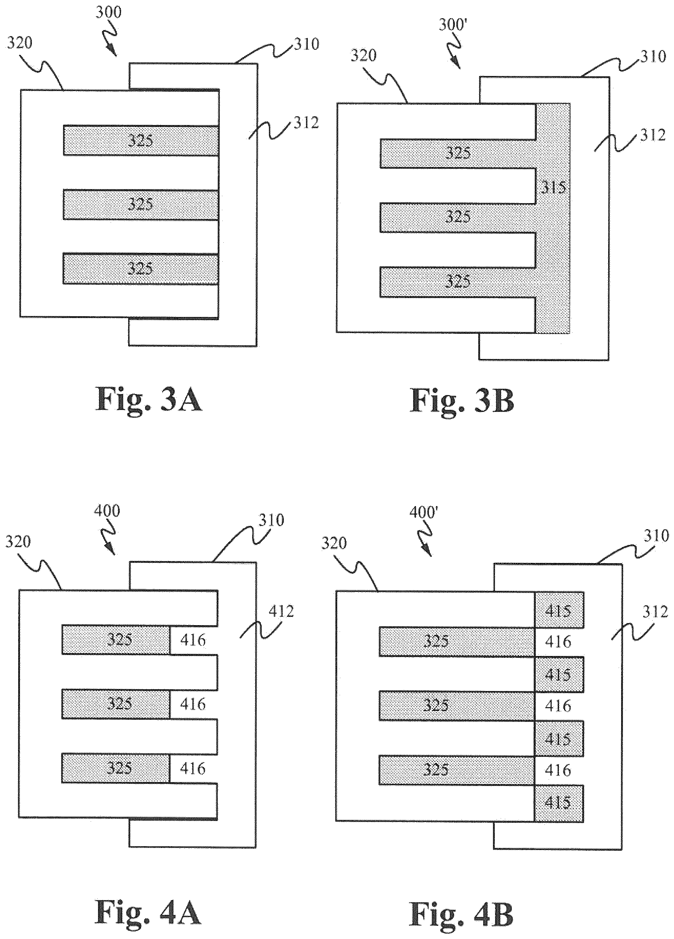

Figs. 3A-B illustrates one embodiment of an adjustable shadow mask assembly, such as shadow mask assembly 200, in a closed position 300 and in an open position 300'. The shadow mask assembly comprises a vertical exposure member 310 having an elongated vertical opening 315 for selective exposure of the substrate to a vertically-elongated ion beam when the assembly is in the open position 300'. In the open position 300', the vertical wall 312 of the vertical exposure member 310 is offset from the horizontal exposure member 320, thereby forming the elongated vertical opening 315. In the open position 300', the vertical wall 312 of the vertical exposure member 310 is in contact with the horizontal exposure member 320, thereby blocking the elongated vertical opening 315. The horizontal exposure member 320 comprises multiple horizontal openings 325 for selective exposure of the substrate to multiple horizontally-elongated ion beams.

Figs. 4A-B illustrates another embodiment of an adjustable shadow mask assembly in a closed position 400 and an open position 400'. The shadow mask assembly in Figs. 4A-B is the same as in Figs. 3A-B, except that the vertical exposure member 310 comprises an interdigitated vertical opening 415 formed by spaced-apart horizontal walls 416 that extend from the vertical wall 312. Since the horizontal implantations can overlap the vertical implantations, this configuration helps avoid the double-dosing of the vertical implantations.

In some embodiments, the stage speed can be dynamically adjusted while processing the substrate with the energetic ion sources, either with or without the fast shutter movement. The stage speed is the velocity at which the implantation beam scans the substrate during a particular stage of the implantation, such as the during the horizontal-only implantation stage and the horizontal-and-vertical implantation stage.

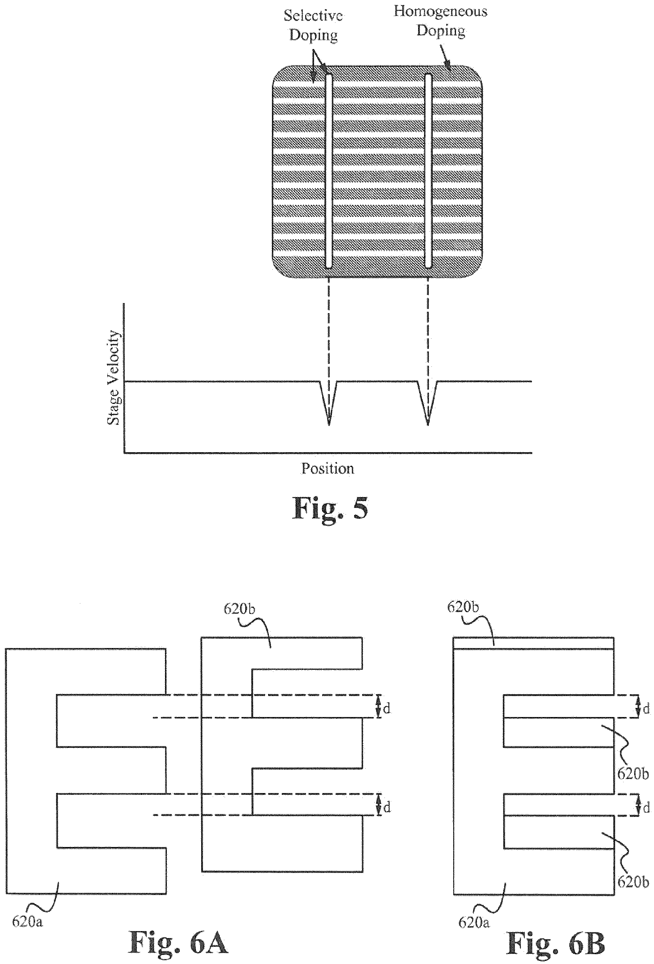

Fig. 5 is a graph illustrating one embodiment of a stage speed control scheme in accordance with the principles of the present invention. In some embodiments, the stage can be slowed down for certain area of the substrate while being processed under the shadow mask, such as for the busbars to receive the intended dopant dose or exposure. The stage speed is then dynamically varied as a function of substrate location or the mask or implantation beam location with respect to the substrate.

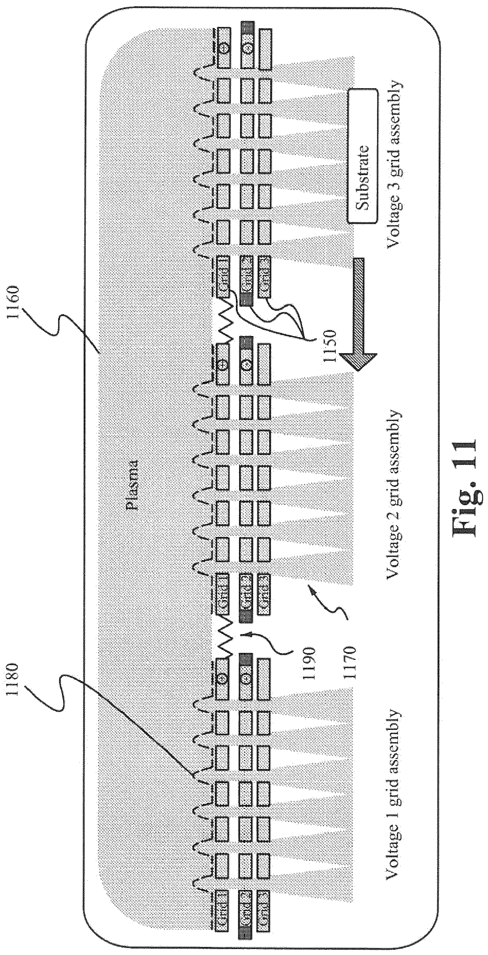

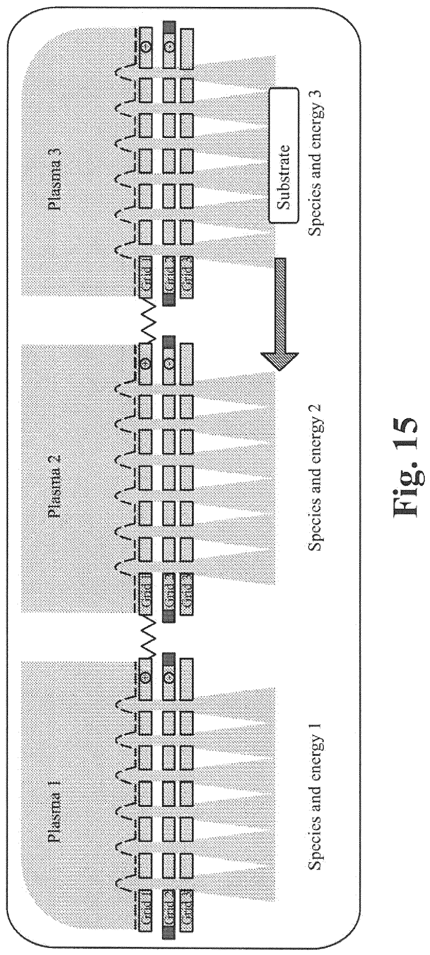

Manufacturing shadow masks can be difficult and costly given the challenge of achieving small exposure openings, such as the multiple horizontal exposure openings. Photolithography can be used to cut out the mask patterns, but it is very expensive. Masks are consumable and will erode after so many exposures to ion beams, thus requiring them to be changed. Another feature of the present invention is the use of offset stackable shadow masks to define the finer features, such as the horizontal exposure openings, using much larger, more easily manufacturable and cost effective patterns. Two or more stacking shadow masks can be used to achieve these finer features by offsetting the same or different patterns on two masks, where a primary mask with a certain opening is occluded by an occlusion mask of similar or varying opening. Such a mask can be either hard mask or made from disposable material for renewable usage of the mask assembly. In particular for the solar industry, it is imperative to implement the most cost effective process manufacturing method possible. This invention can drastically reduce the cost of manufacturing the desired shadow mask patterns without using more expensive manufacturing method such as lithography, etching or laser patterning to define the pattern on the shadow mask. In contrast, a more conventional and simpler mechanical cutting or wire EDM method, which tends to have poorer dimensional specifications at such precise and very small openings, can be used to manufacture the larger features on two shadow masks. The two masks can be then stacked together to effectively define much smaller patterns. Such a stacked shadow mask assembly can define any pattern scale down to zero micrometers. Indeed, any pattern or shape can be constructed. For interdigitated selective lines, one could image a series of masks that, with an automated and slight movement, could transfer the opening from one selective line to the other, as a substrate translates under varying species plasmas and varying energized grids (as will be discussed in further detail below with respect to Figs. 11 and 15).

Fig. 6A illustrates an exploded view of one embodiment of an occlusion mask assembly. Here, first shadow mask 620a has horizontal openings that are offset from the horizontal openings of second shadow mask 620b. When stacked together, as seen in Fig. 6B, this offset of opening creates a much smaller opening, represented by the dotted lines and distance d. Since the shadow masks 620a and 620b with big horizontal openings are much less expensive to fabricate than one shadow mask with very small horizontal openings, the present invention's offset configuration can be used to achieve the small horizontal openings at a cost significantly less. 100 micron mask openings are very difficult to fabricate unless you use photolithography. By using two or more offset masks, you can achieve mask openings of 100 microns or less very easily. In some embodiments, spacing between each opening is about 2 mm. So you could make the mask openings about 500 microns wide for the stackable masks and still achieve the 100 micron or less horizontal openings simply by offsetting the wide-opening masks. In another example, two masks fabricated with openings having a thickness between 100 and 200 microns can be stacked with their openings offset to produce resulting exposure openings, and thus implantations, with a thickness of less than 50 microns. Additionally, since the top mask gets most or all of the beam, it can be fabricated from a thinner, less expensive material that can then be thrown away. Furthermore, since the masks can be separated, a voltage can be applied to them in order to provide an optical means of managing the beam shape. It is contemplated that properties of charged ions can be utilized to shape and form even smaller features by applying varying voltages to the two or more stacked masks. Such independent applications of voltage can be used to change the ionized beam dimension independent of any mechanical movement described above. The spacing of the two or more masks and the masks and wafers can also be used to provide a selective pattern of exposure or a homogeneous pattern. The spacing of the shadow mask assembly from the substrate can also be utilized to provide a better geometrical shaping of the beam, using the space charge properties of the ion beam. It can reside very close to the substrate for best definition of selective doping and evaporation, or can be moved away for better homogeneity of the beam if required.

The present invention provides a wafer processing scheme for different ion implantation energies and species configurations to tailor the dopant junction profiles in the solar cells or semiconductor devices using a plasma grid implanter similar to the plasma grid implantation system disclosed in commonly-owned U.S. Patent Application No. 12/821,053, entitled "PLASMA GRID IMPLANT SYSTEM FOR USE IN SOLAR CELL FABRICATIONS," filed June 22, 2010, and from commonly-owned U.S. Provisional Application No. 61/219,379, entitled "PLASMA GRID IMPLANT SYSTEM FOR USE IN SOLAR CELL FABRICATIONS," filed June 23, 2009, which are both hereby incorporated by reference as if set forth herein, and the features of which can be incorporated into the present invention.

Fig. 11 illustrates one embodiment of a plasma grid implantation system similar to the plasma grid implantation system disclosed in the [Omicron] 53 and '379 patent applications. In order to tailor the dopant junction profile of interest, the target substrate 1140 can be implanted at different ion energies, as the junction depth is a function of the ion energy and the ion species. The moving substrate 1140 is subjected to different ion implantation energies using differential high voltage extraction electrode configurations, as shown in Fig. 11. In this example, three (or multiplicity of) different high voltage power supplies are connected to the three high voltage electrodes, each connected by voltage dividers 1190. The outcome of the dopant junction is the envelope of three individual dopant profiles generated by each ion implantation energy step. Such spaced out series of grid assemblies individually or in combination provides the desired exposure on a mask.

The system comprises a chamber that houses a first (top) grid plate, a second (middle) grid plate, and a third (bottom) grid plate. These grid plates 1150 can be formed from a variety of different materials, including, but not limited to, graphite, silicon carbide, and tungsten. Each grid plate comprises a plurality of apertures configured to allow ions to pass therethrough. A plasma source provides a plasma to a plasma region 1160 of the chamber. This plasma region is located above the first grid plate. In some embodiments, the chamber walls are configured to repel ions in the plasma region using an electric field. For example, in some embodiments, one or more magnets are coupled to the wall of the chamber. The magnetic field is used to push the plasma off the walls, thereby maintaining a gap between the plasma and the chamber walls, and avoiding any sputtering off of the wall material into the plasma. A target substrate 1140 is positioned on the opposite side of the grid plates 1150. The target substrate 1140 can be supported by an adjustable substrate holder, thereby allowing the target substrate to be adjusted between a homogeneous implant position and a selective implant position.

In some embodiments, plasma ions 1170 are accelerated towards the target substrate 1140 by application of a DC or pulsed potential to the first grid plate. These ions are implanted into the substrate 1140.

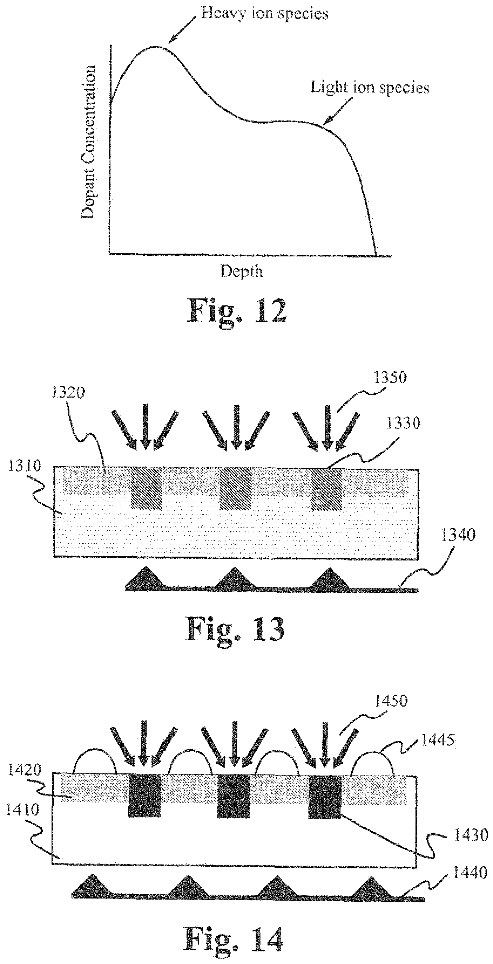

The deleterious effect of secondary electrons resulting from the impingement of ions on the substrate 1140 and other materials is avoided through the use of the second grid plate, which is negatively-biased with respect to the first grid plate. This negatively-biased second grid plate suppresses the electrons that come off of the substrate. In some embodiments, the first grid plate is biased to 80 kV and the second grid plate is biased to -2 kV. However, it is contemplated that other biasing voltages can be employed. The third grid plate acts as a beam defining grid and is preferably grounded. It is positioned in contact with or very close to the surface of the substrate in order to provide a final definition of the implant. This third grid plate can act as a beam defining mask and provide the critical alignment required, if a selective implant is required. The third grid plate can also be replaced or supplemented with any form of beam shaping that does not require a mask, such as the pulsed beam shaping embodiment of FIGS. 13-14 discussed below.

This grid plate assembly arrangement enables the use of DC or pulsed bias for the acceleration of ions and minimizes the back streaming electrons that has hampered plasma immersion technology by limiting the energy range and making the pulser /PSU cost prohibitive. This dramatically simplifies the power supply needed.

Additionally, by decoupling the plasma formation from the ion acceleration, the present invention allows for independent methods to be used for the formation of the plasma above the grid plates. The grid plates can provide some degree of beam definition. For example, the extracted ion beam can be focused to a particular dimension of selective emitter applications.

In this plasma grid implant system, the chamber is configured to allow the plasma to form and expand. As previously discussed, the first grid plate is at a positive potential with respect to ground. By shaping this biased grid plate (electrode) and managing the shape of the meniscus 1180 formed above each of its openings, ions are extracted and optically shaped.

A beam of ions exiting past an aperture is divergent by its nature, which is because the typical equilibrium of plasma is convex. The ions repel each other because of their like electric charge and they have randomly orientated velocities due to thermal motion within the plasma. Therefore, careful design of the grid plate apertures and the plasma condition is necessary to control both the emittance of ions and system acceptance to the ion beam. The emittance is a measure of the beam quality. Typically, high quality beams have low emittance, which means minimal loss of ions during transmission. This has to be balanced against the system specific phase-space boundary such that the beam fits within this boundary or has good acceptance.

The control of ion divergence in the system of the present invention is achieved primarily through adjusting the shape of the ensuing meniscus 1180 at the plasma boundary as it enters the first grid plate electrode. Such shaping can be controlled by adjusting the voltage difference between various electrodes, the shapes of the opening and spacing between various electrodes, the temperature of the plasma, how much plasma gas is used, the density of the plasma and the ion species and current being extracted. For the concave dome shape of meniscus 1180, the second grid plate has to have a negative potential with respect to the first grid plate, and the plasma ion density has to be less than the plasma boundary. Although Fig. 11 shows meniscus 1180 having the shape of a dome, it is contemplated that the meniscus 1180 can be managed in the form of other shapes as well, including, but not limited to, a complete inversion of the dome shape. The shape of the meniscus 1180 can be used to shape the resulting ion implantation beam. Whereas a dome-shaped meniscus, such as meniscus 1180 shown in Fig. 11, will typically result in a narrowed beam, an inverted dome-shaped meniscus will typically result in an expanding beam. The system in Fig. 11 comprises three separate grid assemblies that the substrate 1140 passes under. Each grid assembly has a different voltage applied to it, resulting in different ion energies. In some embodiments, as shown in Fig. 11, voltage dividers 1190 are coupled between neighboring grid assemblies, thereby dropping the voltage from one grid assembly to another while being able to use the same power supply. Such a configuration is advantageous for successive implantations of the substrate 1140. Each grid assembly can facilitate a different kind of implantation within the same system and using the same plasma source. Since homogeneous doping usually requires less energy, the substrate 1140 can start off with selective doping of the horizontal contact regions and vertical busbar regions using the first grid assembly on the right. This stage can then be followed by a homogeneous doping using the next grid assembly to the left. Also, differing plasmas of varying species or combination of species can be used over each of the varying voltage grid assemblies to generate doping profiles of differing shapes, species, and type. Accordingly, although Fig. 11 shows one shared plasma chamber and plasma among the three grid assemblies, in some embodiments, the plasma chamber is split into isolated sections so that each grid assembly can have its own plasma chamber, such as shown in Fig. 15.

Referring back to the stacked mask assembly, it will also allow for better cooling capability of the mask that is impacted by the beam. The cooling lines can be sandwiched between masks and ensure repeatable spacing between the masks. The cooling lines can be used as insulation of the various mask for the application described above. In some embodiments, the temperature of one or more of the stackable shadow masks can be monitored. In some embodiments, cooling lines or channels are provided on the masks to help cool and regulate the temperature of the mask. The mask can also be preheated to help handle the heat of the implantation beams. The temperature of the shadow mask can be monitored and maintained at the same level, either elevated or cooled. In some embodiments, one or more of the masks are formed from a silicon material, including, but not limited to, silicon carbide. In some embodiments, one or more of the masks comprises a silicon coating, such as a silicon carbide coating.

Additionally, in some embodiments, the present invention can use the current arriving at the shadow mask as a means of monitoring the implantation system's performance. In some embodiments, the implantation system is configured to measure the beam current passing through the shadow mask. For example, the system can calculate what fraction of the total beam actually passes through the shadow mask to the substrate based on the ratio of the area of the opening(s) in the shadow mask to the area of the shadow mask. This feature can function as a simple beam current metrology tool. In some embodiments, the implantation system can be configured to make adjustments based on it's monitoring of the implantation if a certain predetermined condition arises.

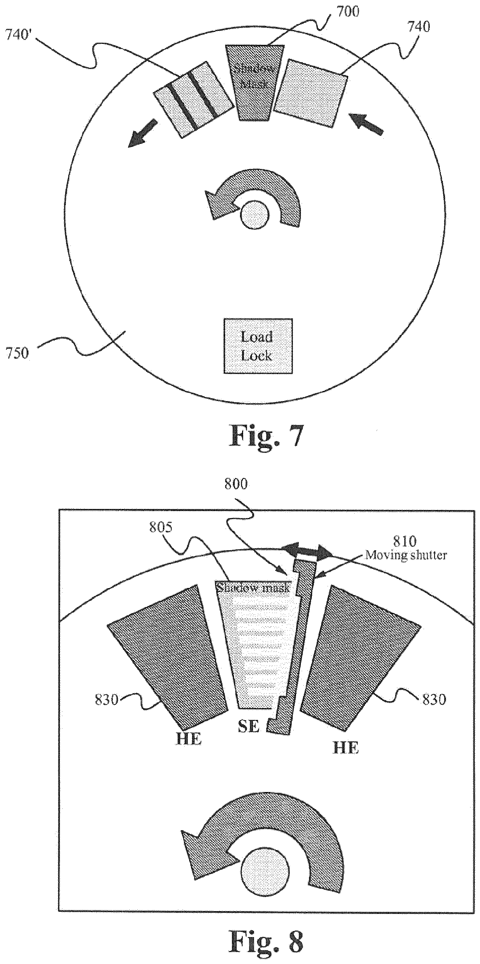

In another aspect of the present invention, the substrate can be processed in a rotating process stage, as shown in Fig. 7. The substrate 740 is introduced to a vacuum environment using a load lock chamber 750 and is rotated at the pre-determined stage speed to expose the substrate 740 to the energetic ion sources through shadow mask assembly 700, such as the shadow mask assemblies previously discussed. The processed substrate 740' is then moved out of the process vacuum environment using the same load lock chamber 750 to the atmospheric pressure for additional processes.

Similar to the in-line system in Fig. 1, the homogeneous emitter (HE) or the selective emitter (SE) or both can be processed in this configuration.

Fig. 8 illustrates a system used for wafer scanning in a rotational processing stage platform. The rotational processing stage platform comprises a shadow mask assembly 805 comprising a shadow mask 805 and an adjustable shutter 810, as described above. The shadow mask assembly 800 is positioned between two homogeneous exposure regions 830.

The pattern of opening is uniquely curved and/or angled to adjust for the rotational movement of the wafers. Such arcing or wedge-shaped opening can be occluded to provide a similar pattern of exposure as the linear system described above. In other embodiments a stop-exposure move can also be employed with a similar desired effect. As described above, the substrate to be processed is introduced through the load lock chamber to the rotating processing stage. While moving near the shadow mask 805, the substrate can be exposed to the energetic ions for the homogeneous emitter application step 830. When the substrate is moved under the shadow mask 805, the selective emitter processing is carried out while the subsequent substrate is being loaded via the load lock. In this particular example, only the first half of the substrate is being exposed under the shadow mask 805. During this exposure, the subsequent substrate is being loaded through the load lock. In some embodiments, the sequencing is described as follow: TSEI = Load lock loading time TSE2 = Load lock unloading time Rotational velocity of process stage, C5 = v / R Where R = radius of process stage and v = (substrate size) / THE Using this scheme, either the homogeneous emitter (HE) or selective emitter (SE) or both can be processed in this configuration, as in the in-line system of Fig. 1.

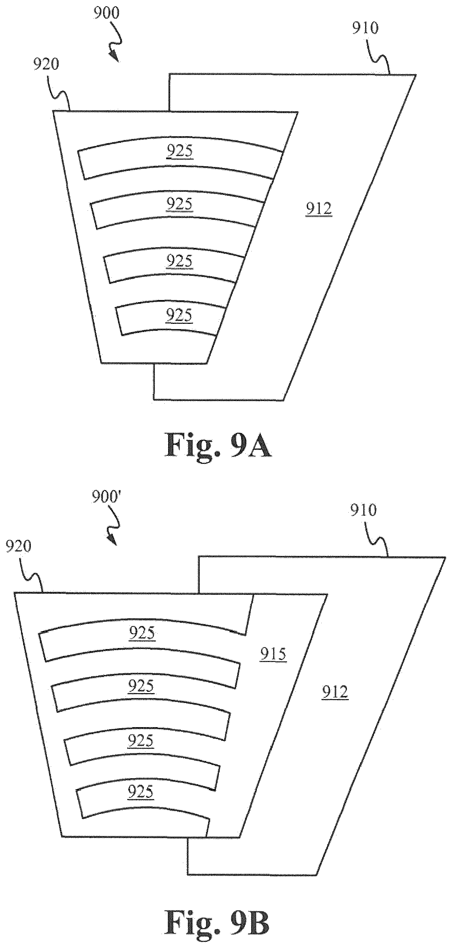

Figs. 9A-B illustrate one embodiment of a wedge-shaped configuration for an adjustable shadow mask assembly, such as shadow mask assembly 200, in a closed position 900 and in an open position 900'. This wedge-shaped configuration accommodates the rotational movement of the wafer.

The shadow mask assembly comprises a vertical exposure member 910 having an elongated vertical opening 915 for selective exposure of the substrate to a vertically-elongated ion beam when the assembly is in the open position 900'. In the open position 900', the vertical wall 912 of the vertical exposure member 910 is offset from the horizontal exposure member 920, thereby forming the elongated vertical opening 915. In the open position 900', the vertical wall 912 of the vertical exposure member 910 is in contact with the horizontal exposure member 920, thereby blocking the elongated vertical opening 915. The horizontal exposure member 920 comprises multiple horizontal openings 925 for selective exposure of the substrate to multiple horizontally-elongated ion beams. In order to accommodate the rotational movement of the substrate, in some embodiments, the farther away from the point of rotation (the bottom of the shadow mask assembly), the longer the horizontal openings 925, since the portions of the substrate towards the outside move along faster and, therefore, need longer exposure. This gradual increase in length from the inside to the outside of the shadow mask assembly provides this additional exposure. Similarly, it is also contemplated that the elongated vertical opening 915 can also be wedge-shaped so that it increases in width as it extends away from the point of rotation.

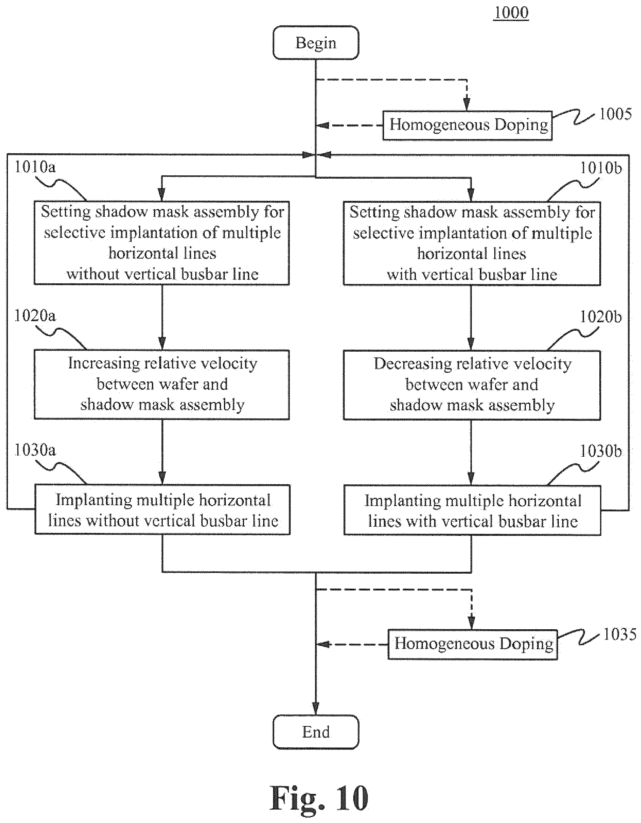

Fig. 10 is a flow chart illustrating on embodiment of a method 1000 of ion implantation in accordance with the principles of the present invention. In this method, a wafer can alternate between selective implantation of multiple horizontal lines without implantation of a vertical busbar line and selective implantation of multiple horizontal lines with implantation of a vertical busbar line. At step 1010a, an adjustable shadow mask assembly, such as those discussed above, is set for selective implantation of multiple horizontal lines without any vertical busbar lines. Here, the shadow mask assembly is adjusted to the appropriate configuration with the elongated vertical opening blocked, if it is not already in this configuration. At step 1020a, the relative velocity between the wafer and the shadow mask assembly is increased, such as by speeding up the movement of the wafer. At step 1030a, multiple horizontal lines are implanted onto the wafer without any implantation of a vertical busbar line.

At step 1010b, the adjustable shadow mask assembly is set for selective implantation of multiple horizontal lines with a vertical busbar line. Here, the shadow mask assembly is adjusted to the appropriate configuration with the elongated vertical opening exposed, if it is not already in this configuration. At step 1020b, the relative velocity between the wafer and the shadow mask assembly is decreased, such as by slowing down the movement of the wafer. At step 1030b, multiple horizontal lines are implanted onto the wafer with an implantation of a vertical busbar line.

As previously mentioned, the method can alternate between selective horizontal line implantation with or without vertical busbar implantation. Additionally, homogeneous doping can be performed at step 1005, before the selective implantation, or at step 1035, after the selective implantation. The present invention also provides a method of tailoring the dopant junction profile in semiconductor devices or solar cell devices by incorporating two or more plasma source gas feed stocks to generate ion species with significantly different masses and/or doping types. Heavier mass ions form a shallower dopant junction profile than those of lighter mass ions.

This characteristic can be utilized to form a dopant junction profile of particular interest, as shown in Fig. 12. Additionally, by adjusting the plasma conditions, a molecular dopant gas or its carrier gas can be divided into the right proportion of individual atomic ions or molecular ions to provide the desired atomic profile within the substrate. The present invention enables efficient homogeneous and selective implantations all within the same implantation system (in some embodiments, the same chamber), such as shown in Fig. 11. In some embodiments, the homogeneous implantation and the selective implantation have different junction profiles, and thus different energies. For example, the homogeneous implant typically requires a shallower junction profile than that of the selective implant.

Fig. 13 illustrates a cross-sectional view of one embodiment of selectively implanting a solar cell by applying a voltage to the substrate in accordance with the principles of the present invention. A localized plasma beam shaping method, such as disclosed in commonly- owned U.S. Patent Application No. 12/821,053, entitled "PLASMA GRID IMPLANT SYSTEM FOR USE IN SOLAR CELL FABRICATIONS," filed June 22, 2010, and from commonly-owned U.S. Provisional Application No. 61/219,379, entitled "PLASMA GRID IMPLANT SYSTEM FOR USE IN SOLAR CELL FABRICATIONS," filed June 23, 2009 (which are both hereby incorporated by reference as if set forth herein, and the features of which can be incorporated into the present invention) can be used to form selective emitter regions 1330 in the semi-conducting substrate 1310, which also has homogeneously doped region 1320. Here, the required pulsing of the beam and an envisaged back surface antenna can be made into a closed loop control so that the ion beams 1350 are directed selectively into certain regions of the substrate. In some embodiments, additional grid structures, such as those previously discussed, could be used to further optimize the shape of the plasma beam, whereby a voltage can be applied, both negative and/or positive, to achieve such shaping. The selected regions 1330 are in alignment with the locations where a voltage 1340 is directly applied to the back surface of the semiconducting wafer 1310. This method may be more applicable for thinner wafers. Alternatively, a combination of the pulsing of the plasma and possible positioning of the substrate can be used to generate areas of high and low doping. Overlapping of these regions can provide an optimized controlled flow of electron holes from the low-doped regions, suited for light conversion, to the highly-doped selectively implanted regions, suited for electrical contact gridlines. One could envisage regions of high and low doping overlaps as the substrate, under precise controlled motions, moves beneath the ion beams. The different regions will not have distinctive boundaries, and a gradual change of doping levels can provide an advantage in flow of charges within the substrate. Such variability in the lateral doping can enhance the operation of the cells.

Fig. 14 illustrates another embodiment of selectively implanting a solar cell by applying a voltage to the substrate in accordance with the principles of the present invention. Similar to the embodiment of Fig. 13, a localized plasma beam shaping method can be used to form selective emitter regions 1430 in the semi-conducting substrate 1410, which also has homogeneously doped region 1420. Here, the required pulsing of the beam and an envisaged back surface antenna can be made into a closed loop control so that the ion beams 1450 are directed selectively into certain regions of the substrate. In some embodiments, additional grid structures, such as those previously discussed, could be used to further optimize the shape of the plasma beam, whereby a voltage can be applied, both negative and/or positive, to achieve such shaping. In contrast to the embodiment of Fig. 13, here the voltage 1440 is directly applied to the back surface of the semiconducting wafer 1410 at certain regions between the desired selective emitter regions 1430 in order to form electrical fields 1445 that direct the ion beams 1450 to the selective emitter regions 1430.

It is contemplated that the present invention can be configured to provide either the embodiment of Fig. 13 or the embodiment of Fig. 14. Furthermore, it is contemplated that a fiat substrate (not shown) with spaced-apart voltage lines could be positioned underneath and in contact with substrate 1310 or substrate 1410, instead of the voltage being applied via the peak configuration shown in Fig. 13 and Fig. 14.

The present invention has been described in terms of specific embodiments incorporating details to facilitate the understanding of principles of construction and operation of the invention. Such reference herein to specific embodiments and details thereof is not intended to limit the scope of the claims appended hereto. It will be readily apparent to one skilled in the art that other various modifications may be made in the embodiment chosen for illustration without departing from the spirit and scope of the invention as defined by the claims.

### List of reference signs

- 100: mask assembly
- 105: beam shutter
- 110: exposure member
- 115: vertical openings
- 120: exposure member
- 125: horizontal openings
- 130: exposure member
- 135: an opening
- 140: the substrate
- 140': resulting substrate
- 200: mask assembly
- 210: exposure member
- 220: exposure member
- 225: horizontal openings
- 300: closed position
- 300': open position
- 310: exposure member
- 312: vertical walls
- 315: elongated vertical opening
- 320: horizontal exposure members
- 325: multiple horizontal openings
- 400: closed position
- 400': open position
- 416: spaced-apart horizontal walls
- 620a: first shadow mask
- 620b: second shadow mask
- 700: shadow mask assembly
- 740: substrate
- 740': processed substrate
- 750: lock chamber
- 800: shadow mask assembly
- 805: shadow mask assembly
- 810: adjustable shutter
- 830: homogenous exposure region
- 900: closed position
- 900': open position
- 910: vertical exposure member
- 915: elongated exposure member
- 920: horizontal exposure member
- 925: multiple horizontal openings
- 1000: embodiment of a method
- 1005: performed at step
- 1010a: at step
- 1010b: at step
- 1020a: at step
- 1020b: at step
- 1030a: at step
- 1030b: at step
- 1035: at step
- 1140: target substrate
- 1150: grid plates
- 1160: plasma region
- 1170: plasma ions
- 1180: ensuing meniscus
- 1190: voltage dividers
- 1310: semi-conducting substrate
- 1320: homogeneously doped regions
- 1330: selective emitter regions
- 1340: voltage
- 1350: ion beams
- 1410: semi-conducting substrate
- 1420: homogeneously doped regions
- 1430: selective emitter regions
- 1440: voltage
- 1450: ion beams

## Claims

1. An adjustable shadow mask implantation system comprising:
an ion source configured to provide ions; and an shadow mask assembly configured to selectively allow ions from the ion source to pass there through to a substrate where they are implanted, wherein the shadow mask assembly is configured to adjust between a first position and a second position, wherein the shadow mask assembly enables ion implantation of multiple substantially parallel lines absent any lines with an intersecting orientation with respect to the multiple substantially parallel lines when set in the first position, and wherein the shadow mask assembly enables ion implantation of multiple substantially parallel lines and a line with an intersecting orientation with respect to the multiple substantially parallel lines when set in the second position.

2. The system of Claim 1, wherein the multiple parallel lines are substantially perpendicular to the line with the intersecting orientation.

3. The system of Claim 1, wherein the shadow mask assembly comprises:
a first exposure region having multiple elongated openings substantially parallel to a first axis; and a second exposure region having an elongated opening substantially parallel to a second axis, wherein the second axis is substantially perpendicular to the first axis, wherein the shadow mask assembly is configured to adjust between the first position and the second position by adjusting the distance between the first exposure region and the second exposure region.

4. The system of Claim 3, wherein the first exposure region comprises:
a first occlusion mask having a first set of elongated openings substantially parallel to a first axis; and a second occlusion mask having a second set of elongated openings substantially parallel to the first axis, wherein the first occlusion mask and the second occlusion mask are configured such that the first set of elongated openings overlap with, but are offset from, the second set of elongated openings to form the multiple elongated openings of the first exposure region, the multiple elongated openings of the first exposure region being smaller than each one of the elongated openings in the first set of the first occlusion mask and the second set of the second occlusion mask.

5. The system of Claim 3, wherein the shadow mask assembly further comprises a homogeneous exposure region configured to enable a blanket homogeneous implantation of the substrate from the ions.

6. The system of Claim 1, further comprising:
a moveable substrate holder configured to move the substrate at a velocity through the path of the ions passing through the shadow mask assembly; and
a controller operationally coupled to the moveable substrate holder, wherein the controller is configured to adjust the velocity to a first level for the first position and to a second level for the second position.

7. The system of Claim 6, wherein the second level is a lower velocity than the first level.

8. The system of Claim 6, wherein the moveable substrate holder is configured to rotate the substrate through the path of the ions passing through the shadow mask assembly.

9. The system of Claim 8, wherein the shadow mask assembly comprises:
a first exposure member having multiple elongated openings substantially parallel to a first axis, wherein the length of the multiple elongated openings is greater the farther away they are from the point of rotation about which the substrate is rotated; and
a second exposure member having an elongated opening configured in an intersecting orientation relative to the first axis, wherein the elongated opening gets wider as it extends away from the point of rotation about which the substrate is rotated,
wherein the shadow mask assembly is configured to adjust between the first position and the second position by adjusting the distance between the first exposure member and the second exposure member.

10. The system of Claim 9, wherein the multiple elongated openings are curved.

11. A method of ion implantation comprising:
flowing ions through a shadow mask assembly to a substrate; adjusting the shadow mask assembly to a first position, wherein the substrate is selectively implanted with multiple substantially parallel lines of ions absent any lines of ions with an intersecting orientation with respect to the multiple substantially parallel lines; and
adjusting the shadow mask assembly to a second position, wherein the substrate is selectively implanted with multiple substantially parallel lines of ions and a line of ions with an intersecting orientation with respect to the multiple substantially parallel lines.

12. The method of Claim 11, wherein the multiple parallel lines are substantially perpendicular to the line with the intersecting orientation.

13. The method of Claim 11 , wherein the shadow mask assembly comprises:
a first exposure region having multiple elongated openings substantially parallel to a first axis; and a second exposure region having an elongated opening substantially parallel to a second axis, wherein the second axis is substantially perpendicular to the first axis,
wherein the shadow mask assembly is configured to adjust between the first position and the second position by adjusting the distance between the first exposure region and the second exposure region.

14. The method of Claim 13, wherein the first exposure region comprises:
a first occlusion mask having a first set of elongated openings substantially parallel to a first axis; and a second occlusion mask having a second set of elongated openings substantially parallel to the first axis, wherein the first occlusion mask and the second occlusion mask are configured such that the first set of elongated openings overlap with, but are offset from, the second set of elongated openings to form the multiple elongated openings of the first exposure region, the multiple elongated openings of the first exposure region being smaller than each one of the elongated openings in the first set of the first occlusion mask and the second set of the second occlusion mask.

15. The method of Claim 13, further comprising flowing ions through a homogeneous exposure region of the shadow mask assembly, thereby providing a blanket homogeneous implantation of the substrate from the ions.

16. The method of Claim 11 , further comprising:
a substrate holder moving the substrate at a velocity through the path of the ions passing through the shadow mask assembly; and
a controller adjusting the velocity to a first level for the first position and to a second level for the second position.

17. The method of Claim 16, wherein the second level is a lower velocity than the first level.

18. The method of Claim 16, wherein the moveable substrate holder rotates the substrate through the path of the ions passing through the shadow mask assembly.

19. The method of Claim 18, wherein the shadow mask assembly comprises:
a first exposure member having multiple elongated openings substantially parallel to a first axis, wherein the length of the multiple elongated openings is greater the farther away they are from the point of rotation about which the substrate is rotated; and a second exposure member having an elongated opening configured in an intersecting orientation relative to the first axis,
wherein the elongated opening gets wider as it extends away from the point of rotation about which the substrate is rotated, wherein the shadow mask assembly is configured to adjust between the first position and the second position by adjusting the distance between the first exposure member and the second exposure member.

20. The method of Claim 19, wherein the multiple elongated openings are curved.

21. The method of Claim 11 , wherein the ions are flown through the shadow mask assembly to the substrate from an ion source, the ion source comprising at least two different ion species having different masses and doping types.

22. The method of Claim 11 , further comprising applying a voltage selectively to spaced apart regions on a side of the substrate opposite the shadow mask assembly, wherein the selective application of voltage promotes the selective implantation of ions.

23. The method of Claim 11 , wherein the shadow mask assembly is part of a first grid assembly, the first grid assembly comprising a first grid plate and a second grid plate, each grid plate of the first grid assembly having a plurality of apertures configured to allow ions to pass there through, the first grid plate of the first grid assembly being positively biased by a power supply, the second grid plate of the first grid assembly being negatively biased by the power supply, the method comprising the ions flowing through the first grid assembly for selective implantation of the substrate.

24. The method of Claim 23, wherein a second grid plate is coupled to the first grid assembly via a voltage divider, the second grid assembly comprising a first grid plate and a second grid plate, each grid plate of the second grid assembly having a plurality of apertures configured to allow ions to pass there through, the first grid plate of the second grid assembly being positively biased by the power supply, the second grid plate of the second grid assembly being negatively biased by the power supply, the method comprising the ions flowing through the second grid assembly for implantation of the substrate.

25. A shadow mask implantation system comprising:
an ion source configured to provide ions; a first occlusion mask having a first set of elongated openings substantially parallel to a first axis; and a second occlusion mask having a second set of elongated openings substantially parallel to the first axis, wherein the first occlusion mask and the second occlusion mask are configured such that the first set of elongated openings overlap with, but are offset from, the second set of elongated openings to form a resulting set of elongated openings through which ions from the ion source are selectively allowed to pass there through to a substrate where they are implanted, each elongated opening of the resulting set being smaller than each elongated opening of the first and second sets.

26. The system of Claim 25, wherein the thickness of each elongated opening of the resulting set is equal to or less than half the thickness of each elongated opening of the first and second sets.

27. The system of Claim 25, wherein the thickness of each elongated opening of the resulting set is equal to or less than 50 microns.

28. The system of Claim 25, further comprising a shadow mask assembly having a first exposure region and a second exposure region, wherein:
the first occlusion mask and the second occlusion mask form the first exposure region comprising the resulting set of elongated openings substantially parallel to the first axis;
the second exposure region has an elongated opening substantially parallel to a second axis, wherein the second axis is substantially perpendicular to the first axis; the shadow mask assembly is configured to adjust between a first position and a second position by adjusting the distance between the first exposure region and the second exposure region;
the shadow mask assembly enables ion implantation of multiple substantially parallel lines absent any lines with an intersecting orientation with respect to the multiple substantially parallel lines when set in the first position, the multiple substantially parallel lines corresponding to the resulting set of elongated openings; and the shadow mask assembly enables ion implantation of multiple substantially parallel lines and a line with an intersecting orientation with respect to the multiple substantially parallel lines when set in the second position, the multiple substantially parallel lines corresponding to the resulting set of elongated openings.

29. The system of Claim 28, wherein the multiple parallel lines are substantially perpendicular to the line with the intersecting orientation.

30. The system of Claim 28, further comprising:
a moveable substrate holder configured to move the substrate at a velocity through the path of the ions passing through the shadow mask assembly; and
a controller operationally coupled to the moveable substrate holder, wherein the controller is configured to adjust the velocity to a first level for the first position and to a second level for the second position, the second level being a lower velocity than the first level.

31. A method of ion implantation comprising:
flowing ions through a shadow mask assembly to a substrate, wherein the shadow mask assembly comprises a first occlusion mask having a first set of elongated openings substantially parallel to a first axis and a second occlusion mask having a second set of elongated openings substantially parallel to the first axis, wherein the first occlusion mask and the second occlusion mask are configured such that the first set of elongated openings overlap with, but are offset from, the second set of elongated openings to form a resulting set of elongated openings through which ions from the ion source are selectively allowed to pass there through to the substrate, each elongated opening of the resulting set being smaller than each elongated opening of the first and second sets; and implanting the ions into the substrate, thereby forming multiple substantially parallel lines of ion implantations corresponding to the resulting set of elongated openings.

32. The method of Claim 31, wherein the thickness of each elongated opening of the resulting set is equal to or less than half the thickness of each elongated opening of the first and second sets.

33. The method of Claim 31, wherein the thickness of each elongated opening of the resulting set is equal to or less than 50 microns.

34. The method of Claim 31, wherein:
a shadow mask assembly has a first exposure region and a second exposure region;
the first occlusion mask and the second occlusion mask form the first exposure region comprising the resulting set of elongated openings substantially parallel to the first axis;
the second exposure region has an elongated opening substantially parallel to a second axis, wherein the second axis is substantially perpendicular to the first axis; the shadow mask assembly is configured to adjust between a first position and a second position by adjusting the distance between the first exposure region and the second exposure region;
the shadow mask assembly enables ion implantation of multiple substantially parallel lines absent any lines with an intersecting orientation with respect to the multiple substantially parallel lines when set in the first position, the multiple substantially parallel lines corresponding to the resulting set of elongated openings; and the shadow mask assembly enables ion implantation of multiple substantially parallel lines and a line with an intersecting orientation with respect to the multiple substantially parallel lines when set in the second position, the multiple substantially parallel lines corresponding to the resulting set of elongated openings.

35. The method of Claim 34, wherein the multiple parallel lines are substantially perpendicular to the line with the intersecting orientation.

36. The method of Claim 34, further comprising:
a moveable substrate holder moving the substrate at a velocity through the path of the ions passing through the shadow mask assembly; and a controller adjusting the velocity to a first level for the first position and to a second level for the second position, the second level being a lower velocity than the first level.
